# EUROPEAN PATENT APPLICATION

(11) **EP 1 071 201 A2**
(43) Date of publication of application: **24.01.2001**
(21) Application number: 00304846.9
(22) Date of filing: 08.06.2000
(51) Int. Cl.: H03B 5/12

(54) **Selectable voltage-controlled oscillation circuit**

(30) Priority: 16.06.1999 JP 16978199
(71) Applicant: ALPS ELECTRIC CO., LTD., Ota-ku Tokyo 145 (JP)
(72) Inventor: Baba, Toshiki, c/o Alps Electric Co., Ltd., Tokyo 145 (JP)
(74) Representative: Kensett, John Hinton

(57) **Abstract**

A selectable oscillation circuit includes a first oscillation circuit (1) including a first oscillation transistor (1₁), a second oscillation circuit (2) including a second oscillation transistor (2₁), and a selector circuit (3) including a first selector terminal (4) connected to the first oscillation circuit and a second selector terminal (5) connected to the second oscillation circuit, the selector circuit selectively switching on and off the first oscillation circuit and the second oscillation circuit in accordance with the provision of a selector signal. In the selectable oscillation circuit, the first selector terminal is connected to a grounding terminal of an emitter load, which is connected to the first oscillation transistor, and a grounding terminal of a base-bias resistor of the first oscillation transistor, and the second selector terminal is connected to a grounding terminal of an emitter load, which is connected to the second oscillation transistor, and a grounding terminal of a base-bias resistor of the second oscillation transistor.

## Description

The present invention relates to selectable oscillation circuits, and, more particularly, relates to a selectable oscillation circuit achieving low power consumption of the all oscillation circuits by reducing the amount of dark current flowing through the inactivated oscillation circuit when either of two oscillation circuits is activated using a selector circuit, and an oscillation signal is output from the activated oscillation circuit.

As mobile communication systems used worldwide, DCS (Digital Cellular System) is employed in the United Kingdom, Germany, France, and part of Asia, and GSM (Global System for Mobile Communications) which was adopted as a European standard method for digital cellular phones in 1982 and is employed in Europe, the United States, Africa, and part of Asia.

DCS has 374 working channels and employs GMSK (Gaussian Minimum Shift Keying) as a modulation method. In DCS, a frequency band of 1805 MHz to 1880 MHz is assigned to frequencies for a base station, a frequency band of 1710 MHz to 1785 MHz is assigned to frequencies for a mobile station, and a 1700 MHz frequency band is assigned to oscillation frequencies of the VCO (voltage-controlled oscillator) of the cellular phone. On the other hand, GSM has 124 working channels and employs GMSK as a modulation method. In GSM, a frequency band of 925 MHz to 960 MHz is assigned to frequencies for a base station, a band of 880 MHz to 915 MHz is assigned to frequencies for a mobile station, and a 900 MHz band is assigned to oscillation frequencies of the VCO of the cellular phone.

Since these two mobile communication systems, namely, DCS and GSM, basically employ different communication methods, two cellular phones are required in order to subscribe to the DCS and GSM mobile communication systems: a cellular phone adopting the DCS method and a cellular phone adopting the GSM method.

However, since the DCS and GSM methods employ the GMSK modulation method, and only their assigned operating frequencies are different, there has been proposed a cellular phone which can be used for both the DCS and GSM systems. In this cellular phone, there is provided a selectable oscillation circuit which has a first voltage-controlled oscillation circuit oscillating in 1700 MHz band, a second voltage-controlled oscillation circuit oscillating in the 900 MHz band, and a selector circuit, whereby this cellular phone is controlled so as to select and properly use from among the two voltage-controlled oscillation circuits in accordance with a control signal from the selector circuit of the selectable oscillation circuit.

In this cellular phone having DCS/GSM modes, when mobile communication is performed using the DCS method, by causing the selector circuit to activate the first voltage-controlled oscillation circuit and to inactivate the second voltage-controlled oscillation circuit, the oscillation output can be obtained from the first voltage-controlled oscillation circuit. On the other hand, when mobile communication is performed using the GSM method, by causing the selector circuit to inactivate the first voltage-controlled oscillation circuit and to activate the second voltage-controlled oscillation circuit, the oscillation output can be obtained from the second voltage-controlled oscillation circuit.

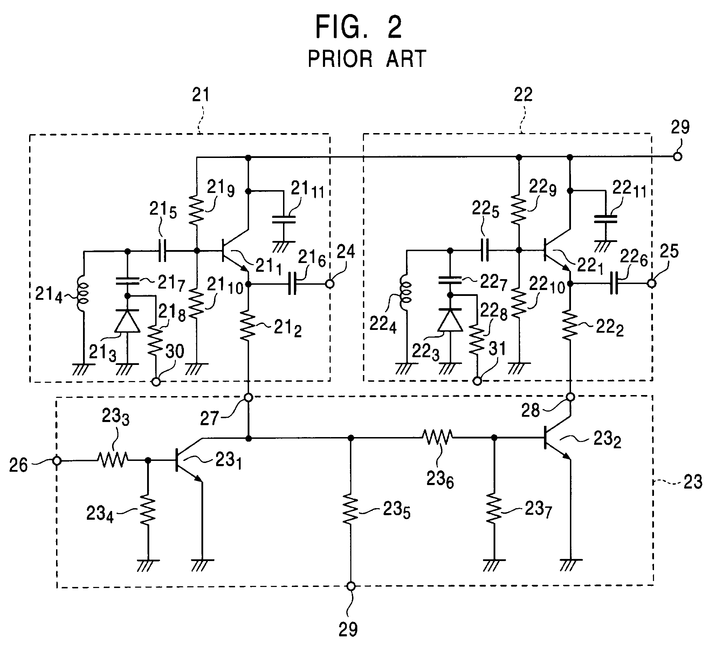

Fig. 2 shows one example of the construction of a known selectable oscillation circuit in the cellular phone having DCS/GSM modes.

As shown in Fig. 2, the known selectable oscillation circuit includes a first voltage-controlled oscillation circuit 21 oscillating in the 1700 MHz band, a second voltage-controlled oscillation circuit 22 oscillating in the 900 MHz band, a selector circuit 23, a first oscillation-signal output terminal 24, a second oscillation-signal output terminal 25, a selector-signal supply terminal 26, a first selector terminal 27, a second selector terminal 28, a power supply terminal 29, a first frequency-setting voltage-supply terminal 30, and a second frequency-setting voltage-supply terminal 31.

The first voltage-controlled oscillation circuit 21 includes a first oscillation transistor 21₁, an emitter load resistor 21₂, a varactor diode 21₃, an inductor 21₄, coupling capacitors 21₅ and 21₆, a direct-current-decoupling capacitor 21₇, a buffer resistor 21₈, base-bias resistors 21₉ and 21₁₀, and a bypass capacitor 21₁₁. These circuit elements 21₁ to 21₁₁ are coupled as shown in Fig. 2. The varactor diode 213 and the inductor 21₄ mainly constitute a first resonator circuit which determines the oscillation frequency of the first voltage-controlled oscillation circuit 21. A predetermined frequency in the 1700 MHz band, which is obtained by changing a first frequency-setting voltage provided via the first frequency-setting voltage-supply terminal 30 to the varactor diode 21₃, is set as the resonant frequency of the first resonant circuit.

The second voltage-controlled oscillation circuit 22 (substantially the same construction as the above-described circuit 21) includes a second oscillation transistor 22₁, an emitter load resistor 22₂, a varactor diode 22₃, an inductor 22₄, coupling capacitors 22₅ and 22₆, a direct-current-decoupling capacitor 22₇, a buffer resistor 22₈, base-bias resistors 22₉ and 22₁₀, and a bypass capacitor 22₁₁. These circuit elements 22₁ to 22₁₁ are connected as shown in Fig. 2. The varactor diode 22₃ and the inductor 22₄ mainly constitute a second resonator circuit which determines the oscillation frequency of the second voltage-controlled oscillation circuit 22. A predetermined frequency in the 900 MHz band, which is obtained by changing a second frequency-setting voltage provided via the second frequency-setting voltage-supply terminal 31 to the varactor diode 22₃, is set as the resonant frequency of the second resonant circuit.

The selector circuit 23 includes a first switching transistor 23₁, a second switching transistor 23₂, and resistors 23₃, 23₄, 23₅, 23₆, and 23₇, which are connected as shown in Fig. 2.

The known selectable oscillation circuit having the above-described construction operates as follows.

In the cellular phone, when mobile communication is performed using the DCS method, a HIGH-level (saturated) selector signal is provided to the selector-signal supply terminal 26 of the selector circuit 23, which switches the first switching transistor 23₁ on and the second switching transistor 23₂ off. At this time, the emitter load resistor 21₂ connected to the first oscillation transistor 21₁ is grounded via the collector-emitter path of the first switching transistor 23₁, which allows an operating current to flow from the collector-emitter path of the first oscillation transistor 21₁. Accordingly, normal oscillation occurs in the first voltage-controlled oscillation circuit 21. The first frequency oscillation signal (whose oscillation frequency is in the 1700 MHz band) obtained at the first oscillation transistor 21₁ is provided from the emitter thereof via the coupling capacitor 21₆ to the first oscillation-signal output terminal 24. Finally, the first frequency oscillation signal is provided to an application circuit (not shown). At this time, since the second switching transistor 23₁ is switched off, the emitter load resistor 22₂ connected to the second oscillation transistor 22₁ is not grounded, which prevents an operating current from flowing via the collector-emitter path of the second oscillation transistor 22₁. Accordingly, the second voltage-controlled oscillation circuit 22 does not oscillate.

On the other hand, when mobile communication is performed using the GSM method, a LOW-level selector signal (non-conducting) is provided to the selector-signal supply terminal 26 of the selector circuit 23, which switches the first switching transistor 23₁ off and the second switching transistor 23₂ on. At this time, since the second switching transistor 23₂ is switched on, the emitter load resistor 22₂ connected to the second oscillation transistor 22₁ is grounded via the collector-emitter path of the second switching transistor 23₂, which allows the operating current to flow from the collector-emitter path of the second oscillation transistor 22₁. Accordingly, normal oscillation occurs in the second voltage-controlled oscillation circuit 22. The second frequency oscillation signal (whose oscillation frequency is in the 900 MHz band) obtained at the second oscillation transistor 22₁ is provided from the emitter of the second oscillation transistor 22₁ via the coupling capacitor 22₆ to the second oscillation-signal output terminal 25. Finally, the second frequency oscillation signal is provided from the second oscillation-signal output terminal 25 to the application circuit (not shown). At this time, since the first switching transistor 23₁ is switched off, the emitter load resistor 21₂ connected to the first oscillation transistor 21₁ is not grounded, which prevents the operating current from flowing via the collector-emitter path of the first oscillation transistor 21₁. Therefore, the first voltage-controlled oscillation circuit 21 stops oscillating.

Thus, by providing the HIGH level or the LOW level selector signal to the selector-signal supply terminal 26, either the first voltage-controlled oscillation circuit 21 or the second voltage-controlled oscillation circuit 22 is selectively activated. Accordingly, the first frequency oscillation signal or the second frequency oscillation signal can be selectively output.

In accordance with whether the selector signal provided to the selector circuit 23 is HIGH or LOW, one (for example, the first voltage-controlled oscillation circuit 21) of the voltage-controlled oscillation circuits 21 and 22 is activated and the other (for example, the second voltage-controlled oscillation circuit 22) is inactivated. In this case, when the second switching transistor 23₂ is switched off, since the operating current does not flow via the collector-emitter path of the second oscillation transistor 22₁, there is no power consumption due to the operating current flowing via the collector-emitter path. However, regardless of whether or not the second oscillation transistor 22₁ is active, a bias-setting current continues to flow via the base-bias resistors 22₉ and 22₁₀. Since the power consumption due to the bias-setting current flowing via the base-bias resistors 22₉ and 22₁₀ cannot be eliminated, the internal battery of the cellular phone is drained more quickly.

Accordingly, in view of the foregoing technical background, it is an object of the present invention to provide a selectable oscillation circuit for reducing the power consumption in an inactive oscillation circuit to substantially zero when a selector circuit causes one of two oscillation circuits to be activated and the other to be inactivated.

To this end, there is provided a selectable oscillation circuit which includes a first oscillation circuit having a first oscillation transistor, a second oscillation circuit including a second oscillation transistor, and a selector circuit including a first selector terminal connected to the first oscillation circuit and a second selector terminal connected to the second oscillation circuit, the selector circuit selectively switching on and off the first oscillation circuit and the second oscillation circuit in accordance with the provision of a selector signal. In the selectable oscillation circuit, the first selector terminal is connected to a grounding terminal of an emitter load, which is connected to the first oscillation transistor, and a grounding terminal of a base-bias resistor of the first oscillation transistor, and the second selector terminal is connected to a grounding terminal of an emitter load, which is connected to the second oscillation transistor, and a grounding terminal of a base-bias resistor of the second oscillation transistor.

When the first transistor is switched off, all current flowing via the first oscillation circuit can be blocked. In the same manner, when the second transistor is switched off, all current flowing via the second oscillation circuit can be blocked. Therefore, since unnecessary power consumption is suppressed, the battery loss can be minimized.

Further objects, features, and advantages of the present invention will become apparent from the following description of the preferred embodiments with reference to the attached drawings.

Embodiments of the invention will now be described, by way of example only, with reference to the accompanying drawings, in which:
Fig. 1 is a circuit diagram of a selectable oscillation circuit according to one embodiment of the present invention; and
Fig. 2 is a circuit diagram of a known selectable oscillation circuit.

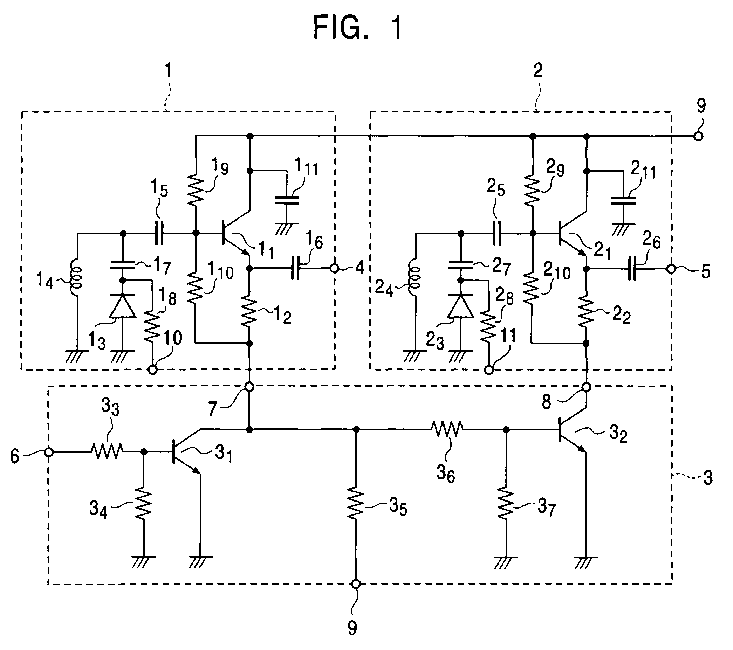

Fig. 1 shows the construction of a selectable oscillation circuit according to an embodiment of the present invention, which is used in a cellular phone having DCS/GSM modes.

As shown in Fig. 1, the selectable oscillation circuit includes a first voltage-controlled oscillation circuit 1 oscillating in a 1700 MHz band, a second voltage-controlled oscillation circuit 2 oscillating in a 900 MHz band, a selector circuit 3, a first oscillation-signal output terminal 4, a second oscillation-signal output terminal 5, a selector-signal supply terminal 6, a first selector terminal 7, a second selector terminal 8, a power supply terminal 9, a first frequency-setting voltage-supply terminal 10, and a second frequency-setting voltage-supply terminal 11.

The first voltage-controlled oscillation circuit 1 includes a first oscillation transistor 1₁, an emitter load resistor 1₂, a varactor diode 1₃, an inductor 1₄, coupling capacitors 1₅ and 1₆, a direct-current-decoupling capacitor 1₇, a buffer resistor 1₈, base-bias resistors 1₉ and 1₁₀, and a bypass capacitor 1₁₁. These circuit elements 1₁ to 1₁₁ are coupled as shown in Fig. 1. The varactor diode 1₃ and the inductor 1₄ mainly constitute a first resonator circuit which determines the oscillation frequency of the first voltage-controlled oscillation circuit 1. A predetermined frequency in the 1700 MHz band, which is obtained by changing a negative-HIGH first frequency-setting voltage provided via the buffer resistor 1₈ from the first frequency-setting voltage-supply terminal 10 to the varactor diode 1₃, is selectively set as the resonant frequency of the first resonant circuit.

The second voltage-controlled oscillation circuit 2 (substantially the same construction as the above-described oscillation circuit 1) includes a second oscillation transistor 2₁, an emitter load resistor 2₂, a varactor diode 2₃, an inductor 2₄, coupling capacitors 2₅ and 2₆, a direct-current-decoupling capacitor 2₇, a buffer resistor 2₈, base-bias resistors 2₉ and 2₁₀, and a bypass capacitor 2₁₁. These circuit elements 2₁ to 2₁₁ are coupled as shown in Fig. 1. The varactor diode 2₃ and the inductor 2₄ mainly constitute a second resonator circuit which determines the oscillation frequency of the second voltage-controlled oscillation circuit 2. A predetermined frequency in the 900 MHz band, which is obtained by changing a negative-HIGH second frequency-setting voltage provided via the buffer resistor 2₈ from the second frequency-setting voltage-supply terminal 11 to the varactor diode 2₃, is selectively set as the resonant frequency of the second resonant circuit.

The selector circuit 3 includes a first switching transistor 3₁, a second switching transistor 3₂, and resistors 3₃, 3₄, 3₅, 3₆, and 3₇, which are coupled as shown in Fig. 1. The resistors 3₃ and 3₄ are base-bias resistors for the first switching transistor 3₁. The resistors 3₅, 3₆, and 3₇ are base-bias resistors for the second switching transistor 3₂. The selector circuit 3 has the same construction as the selector circuit 23 used in the known selectable oscillation circuit shown in Fig. 2.

The selectable oscillation circuit having the above-described construction operates as follows.

In this cellular phone, when mobile communication is performed using the DCS method, in other words, when the selector circuit 3 is selected so that selectable oscillation circuit operates in the 1700 MHz band, a positive-HIGH selector signal is generated by driving a control unit (not shown) and is provided to the selector-signal supply terminal 6 of the selector circuit 3. When the selector circuit 3 receives the positive-HIGH selector signal, the first switching transistor 3₁ is switched on and the second switching transistor 3₂ is switched off. At this time, since the first switching transistor 3₁ is switched on, the emitter load resistor 1₂ connected to the first oscillation transistor 1₁ and the base-bias resistors 1₉ and 1₁₀ are grounded via the collector-emitter path of the first switching transistor 3₁. The grounding of these resistors allows a base-bias-setting current to flow via the two base-bias resistors 1₉ and 1₁₀, which causes a proper base-bias voltage to be applied to the base of the first oscillation transistor 1₁. Because of the application of the proper base-bias voltage, an operating current flows via the collector-emitter path of the first oscillation transistor 1₁. Accordingly, normal oscillation occurs in the first voltage-controlled oscillation circuit 1. The first frequency oscillation signal (whose oscillation frequency is in the 1700 MHz band) obtained at the first oscillation transistor 1₁ is provided from the emitter of the first oscillation transistor 1₁ via the coupling capacitor 1₆ to the first oscillation-signal output terminal 4. Finally, the first frequency oscillation signal is provided to an application circuit (not shown).

At this time, since the second switching transistor 3₂ is switched off, the emitter load resistor 2₂ connected to the second oscillation transistor 2₁ and the base-bias resistors 2₉ and 2₁₀ are not grounded. Since the base-bias resistors 2₉ and 2₁₀ are not grounded, a proper base-bias voltage is not applied to the second oscillation transistor 2₁, and an operating current does not flow via the collector-emitter path thereof. Accordingly, the second voltage-controlled oscillation circuit 2 stops oscillating.

On the other hand, when mobile communication is performed using the GSM method, in other words, when the selector circuit 3 is selected so that selectable oscillation circuit operates in the 900 MHz band, a LOW selector signal is generated from the control unit by driving the control unit and is provided to the selector-signal supply terminal 6 of the selector circuit 3. When the selector circuit 3 receives the LOW selector signal, the first switching transistor 3₁ is switched off and then the second switching transistor 3₂ is switched on. At this time, since the second switching transistor 3₂ is switched on, the emitter load resistor 2₂ connected to the second oscillation transistor 2₁ and the base-bias resistors 2₉ and 2₁₀ are grounded via the collector-emitter path of the second switching transistor 3₂. The grounding of these resistors allows a base-bias-setting current to flow via the two base-bias resistors 2₉ and 2₁₀, which causes a proper base-bias voltage to be applied to the base of the second oscillation transistor 2₁. Because of the application of the proper base-bias voltage, an operating current flows via the collector-emitter path of the second oscillation transistor 2₁. Accordingly, normal oscillation occurs in the second voltage-controlled oscillation circuit 2. The second frequency oscillation signal (whose oscillation frequency is in the 900 MHz band) obtained by the second oscillation transistor 2₁ is provided from the emitter of the second oscillation transistor 2₁ via the coupling capacitor 2₆ to the second oscillation-signal output terminal 5. Finally, the second frequency oscillation signal is provided from the second oscillation-signal output terminal 5 to an application circuit (not shown).

At this time, since the first switching transistor 3₁ is switched off, the emitter load resistor 1₂ connected to the first oscillation transistor 1₁, and the base-bias resistors 1₉ and 1₁₀ are not grounded. Since both of the base-bias resistors 1₉ and 1₁₀ are not grounded, the proper base-bias voltage is not applied to the first oscillation transistor 1₁, and the operating current does not flow via the collector-emitter path thereof. Accordingly, the first voltage-controlled oscillation circuit 1 stops oscillating.

Thus, according to the present invention, one of the first voltage-controlled oscillation circuit 1 and the second voltage-controlled oscillation circuit 2 is selectively switched to be active while the other one is inactive, by switching on-off states of the collector-emitter paths of the first and second oscillation transistors 1₁ and 2₁ and the paths of base-bias-setting currents flowing via the base-bias resistors 1₉, 1₁₀, 2₉, and 2₁₀ in accordance with whether the selector signal provided from the control unit to the selector-signal supply terminal 6 of the selector circuit 3 is the positive-HIGH or LOW. Accordingly, when either the first oscillation circuit 1 or the second oscillation circuit 2 is inactive, because the current does not flow via the inactive oscillation circuit, there is no power consumption at base-bias resistors 1₉ and 1₁₀ or at base-bias resistors 2₉ and 2₁₀, respectively.

In the present embodiment, by way of example, the selectable oscillation circuit, which is used in the cellular phone having the DCS/GSM modes, and in which the frequency of the output oscillation signal from the first voltage-controlled oscillation circuit 1 is in the 1700 MHz band and in which the frequency of the output oscillation signal from the second voltage-controlled oscillation circuit 2 is in the 900 MHz band, is described. However, the selectable oscillation circuit according to the present invention is not limited to the above-described cellular phone, and it may be used in another similar device. Each of the oscillation frequencies of the first and second voltage-controlled oscillation circuits 1 and 2 is not limited to the above-described frequency band. As long as these frequency bands are appropriately discrete, another frequency band may be used.

In the above-described embodiment, by way of example, two oscillation circuits are the first voltage-controlled oscillation circuit 1 and the second voltage-controlled oscillation circuit 2. However, the two oscillation circuits are not necessarily voltage-controlled oscillation circuits and they may generate oscillation signals of predetermined frequency bands.

## Claims

1. A selectable oscillation circuit comprising:
a first oscillation circuit including a first oscillation transistor;
a second oscillation circuit including a second oscillation transistor; and
a selector circuit including a first selector terminal connected to said first oscillation circuit and a second selector terminal connected to said second oscillation circuit, said selector circuit selectively switching on and off said first oscillation circuit and said second oscillation circuit in accordance with the provision of a selector signal,
wherein:
said first selector terminal is connected to a grounding terminal of an emitter load, which is connected to said first oscillation transistor, and a grounding terminal of a base-bias resistor of said first oscillation transistor; and
said second selector terminal is connected to a grounding terminal of an emitter load, which is connected to said second oscillation transistor, and a grounding terminal of a base-bias resistor of said second oscillation transistor.

2. A selectable oscillation circuit according to Claim 1, wherein:
said selector circuit includes a first transistor and a second transistor which are grounded-emitter type transistors and which are dependently direct-current-biased connected; and
the collector of said first transistor is connected to said first selector terminal and the collector of said second transistor is connected to said second selector terminal.

3. A selectable oscillation circuit according to Claim 2, wherein said selector circuit is constructed by establishing connection between a connection part between said first transistor and said second transistor and a base-bias-supply circuit of said second transistor.

4. A selectable oscillation circuit according to Claim 2 or 3, wherein said selector circuit causes a selector signal to be supplied to the base of said first transistor.
